Europäisches Patentamt

European Patent Office

Office européen des brevets

(19)

(11) Numéro de publication : **0 181 808**
B1

(12) **FASCICULE DE BREVET EUROPÉEN**

(45) Date de publication du fascicule du brevet :
26.04.89

(51) Int. Cl.⁴ : **G 01 R 23/165**

(21) Numéro de dépôt : **85402074.0**

(22) Date de dépôt : **25.10.85**

(54) Analyseur de spectre à filtres dispersifs à ondes de surface.

(30) Priorité : 30.10.84 FR 8416600

(43) Date de publication de la demande :
21.05.86 Bulletin 86/21

(45) Mention de la délivrance du brevet :
26.04.89 Bulletin 89/17

(84) Etats contractants désignés :
GB IT

(56) Documents cités :
COLLOGUE INTERNATIONAL SUR LE RADAR DE
1978, session IX.4, pages 303-316; C. LARDAT: "Analyseurs de spectre utilisant des filtres dispersifs à
ondes de surface"

(73) Titulaire : **THOMSON-CSF**
**173, Boulevard Haussmann**
**F-75379 Paris Cédex 08 (FR)**

(72) Inventeur : **Ambos, René**
**THOMSON-CSF SCPI 173, bld Haussmann**
**F-75379 Paris Cedex 08 (FR)**
Inventeur : **Quagliaro, Gilles**
**THOMSON-CSF SCPI 173, bld Haussmann**
**F-75379 Paris Cedex 08 (FR)**
Inventeur : **Fertil, Alain**
**THOMSON-CSF SCPI 173, bld Haussmann**
**F-75379 Paris Cedex 08 (FR)**

(74) Mandataire : **El Manouni, Josiane et al**
**THOMSON-CSF SCPI**
**F-92045 PARIS LA DEFENSE CEDEX 67 (FR)**

Jouve, 18, rue St-Denis, 75001 Paris, France

**Description**

La présente invention concerne un analyseur de spectre à filtres dispersifs à ondes de surface.

Les analyseurs de spectre en temps réel ont connu d'importants développements au cours de ces dernières années et on distingue soit des systèmes entièrement numériques, soit des systèmes utilisant des techniques analogiques, tels que les analyseurs à filtres dispersifs à ondes de surface auxquels se rapporte la présente invention. Ces derniers utilisent par exemple une structure dite « M-C-M » (Multiplication-Convolution-Multiplication), grâce à laquelle le spectre d'un signal à analyser est obtenu en prémultipliant ce signal par une première rampe $R_1(t)$ modulée linéairement en fréquence, de bande B et de durée T, en effectuant ensuite la convolution du signal ainsi obtenu avec une deuxième rampe $R(t)$ modulée linéairement en fréquence, de bande 2B et de durée 2T, et de pente opposée à $R_1(t)$, et en postmultipliant le signal ainsi obtenu par une troisième rampe $R_2(t)$ modulée linéairement en fréquence, de bande B et de durée T, et de pente identique à $R_1(t)$.

Ces rampes de fréquences sont avantageusement obtenues à partir de la réponse impulsionnelle de filtres dispersifs à ondes de surface.

Ainsi la rampe de prémultiplication $R_1(t)$ est obtenue en attaquant un premier filtre dispersif, dit filtre de prémultiplication, par une impulsion de Dirac $\delta_1(t)$. De même la rampe de postmultiplication $R_2(t)$ est obtenue en attaquant un deuxième filtre dispersif, dit filtre de postmultiplication, par une impulsion de Dirac $\delta_2(t)$ qui est déclenchée avec un retard T par rapport à l'impulsion $\delta_1(t)$. Enfin la convolution avec la rampe $R(t)$ est obtenue par passage dans un filtre dispersif, dit filtre de convolution, ayant pour réponse impulsionnelle $R(t)$.

Un analyseur de spectre de ce type est notamment décrit dans la communication IX.4 de C. LARDAT, intitulée « Analyseurs de spectre utilisant des filtres dispersifs à ondes de surface », au Collogue International sur le Radar de 1978 (p. 303 à 311).

Le signal obtenu en sortie de cet analyseur est une impulsion dont la position dans le temps est fonction de la fréquence F à analyser, et plus précisément égale à T + (F/k) (où K est la pente des rampes de fréquences, égale à B/T), dont l'amplitude est proportionnelle à l'amplitude de la raie du spectre du signal à analyser à la fréquence F, et dont la phase est la phase du signal à analyser, à l'instant t = 0. Cette phase est par ailleurs mesurée à un instant de référence $t = t_2 - (T/2)$ où $t_2$ est l'instant de déclenchement de l'impulsion de démodulation $\delta_2(t)$.

En pratique, ces résultats ne sont toutefois pas vérifiés avec exactitude ; notamment la mesure de phase est entachée d'un terme d'erreur qui dépend des variations des caractéristiques des filtres dispersifs avec la température et des défauts de synchronisation de l'impulsion $\delta_2(t)$ par rapport à l'impulsion $\delta_1(t)$. En effet lorsque le retard de déclenchement de l'impulsion $\delta_2(t)$ par rapport à l'impulsion $\delta_1(t)$ n'est pas rigoureusement égal à T, il n'est plus exact de dire que l'instant de mesure de phase est l'instant $t_2 - (T/2)$, et la mesure de phase se trouve alors faussée. Pour les mêmes raisons, la mesure de phase se trouve faussée lorsque la température varie car, les paramètres des lignes dispersives variant, le retard de déclenchement de l'impulsion $\delta_2(t)$ par rapport à l'impulsion $\delta_1(t)$ n'est plus rigoureusement égal à T. Une possibilité de minimiser ces défauts serait de s'attaquer à leur cause en stabilisant en température l'analyseur, mais cette solution n'est généralement pas possible pour des raisons de volume et de consommation ; de plus elle laisse entier le problème des erreurs dues au défaut de synchronisation des impulsions $\delta_2(t)$ et $\delta_1(t)$.

La présente invention a pour objet une structure permettant d'éviter les défauts de phase liés aux erreurs de déclenchement des filtres dispersifs de prémultiplication et de postmultiplication et aux dérives des filtres dispersifs en température, non pas en évitant que ces défauts se produisent, mais en les compensant exactement par des défauts identiques générés par un analyseur de spectre identique placé dans les mêmes conditions et analysant un signal de référence qui est notamment une impulsion de Dirac $\delta(t)$.

L'analyseur de spectre à filtres dispersifs à ondes de surface suivant l'invention (selon la revendication 1), comportant un premier ensemble à structure « M-C-M », c'est-à-dire dans lequel sont effectuées successivement des opérations de prémultiplication, convolution et postmultiplication, respectivement du signal à analyser, du signal obtenu à l'issue de la prémultiplication et du signal obtenu à l'issue de la convolution, par une première, une deuxième et une troisième rampe modulées linéairement en fréquence, ce premier ensemble recevant le signal à analyser, et ces rampes de fréquences étant constituées par la réponse impulsionnelle de filtres dispersifs, respectivement appelés filtres de prémultiplication, de convolution et de postmultiplication, est caractérisé en ce qu'il comporte en outre, d'une part un second ensemble à structure « M-C-M » identique au premier et recevant un signal de référence, les filtres dispersifs respectivement de prémultiplication et de postmultiplication du premier et du second ensembles recevant respectivement le même signal de commande, d'autre part un mélangeur recevant les signaux de sortie du premier et du second ensembles, et fournissant le signal de sortie de l'analyseur de spectre.

La présente invention a également pour objet une simplification de cette dernière structure consistant dans la mise en commun du filtre dispersif de prémultiplication des deux analyseurs (selon la revendication 3), et/ou dans la suppression du filtre dispersif de postmultiplication des deux analyseurs (selon la revendication 4).

L'invention sera mieux comprise au moyen de la description qui suit et des figures annexées parmi lesquelles :

la figure 1 est un schéma d'un analyseur de spectre suivant l'art connu ;

la figure 2 est un premier chéma d'un analyseur de spectre suivant l'invention ;

la figure 3 est un second schéma d'un analyseur de spectre suivant l'invention.

Les éléments communs à ces différentes figures portent les mêmes références.

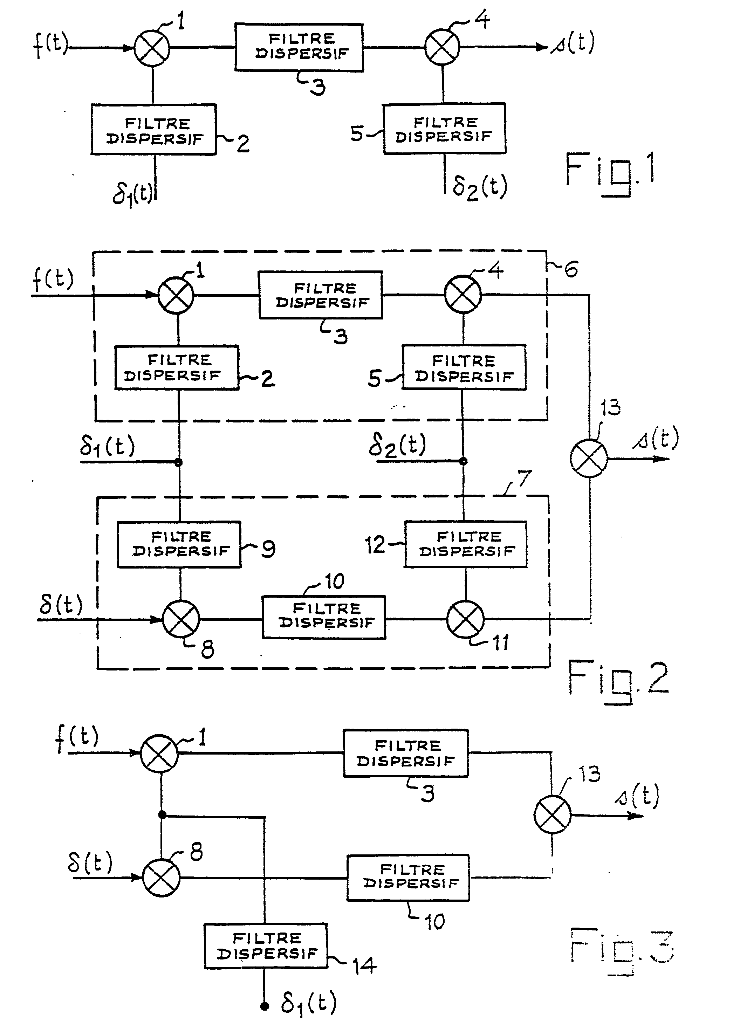

L'analyseur de spectre suivant l'art connu représenté sur la figure 1 comporte un mélangeur 1 qui effectue la prémultiplication d'un signal à analyser f(t) par une rampe $R_1(t)$ modulée linéairement en fréquence obtenue en sortie d'un filtre dispersif à ondes de surface 2, de bande B et de durée T, attaqué par une impulsion de Dirac $\delta_1(t)$. Cet analyseur comporte également un filtre dispersif à ondes de surface 3, de bande 2B, de durée 2T, et de pente opposée à $R_1(t)$, à l'entrée duquel est appliqué le signal de sortie du mélangeur 1, et qui effectue la convolution de ce signal par une rampe R(t) modulée linéairement en fréquence, la rampe R(t) correspondant à la réponse impulsionnelle du filtre dispersif 3. Cet analyseur comporte enfin un mélangeur 4 qui effectue la postmultiplication du signal de sortie du filtre dispersif 3 par une rampe $R_2(t)$ modulée linéairement en fréquence, obtenue en sortie d'un filtre dispersif à ondes de surface 5, de bande B et de durée T, attaqué par une impulsion de Dirac $\delta_2(t)$. Le signal de sortie s(t) de cet analyseur de spectre est obtenu en sortie du mélangeur 4.

On rappelle le fonctionnement de l'analyseur de spectre représenté sur la figure 1.

Le filtre dispersif 2 est un filtre dispersif de bande B et de durée T. On suppose qu'il est déclenché à l'instant t = + (T/2). L'équation du signal obtenu en sortie est alors :

$$s_m(t) = r\left(\frac{t}{T}\right) \cdot e^{-i\pi k t^2}$$

où

$$r\left(\frac{t}{T}\right) = 1 \text{ pour } \left|\frac{t}{T}\right| \leqslant \frac{1}{2},$$

$$r\left(\frac{t}{T}\right) = 0 \text{ pour } \left|\frac{t}{T}\right| > \frac{1}{2},$$

$$k = \frac{B}{T} \quad \text{(pente du filtre dispersif)}.$$

Le filtre dispersif 3 est un filtre dispersif de bande 2B et de durée 2T. Sa réponse impulsionnelle est :

$$s_c(t) = r\left(\frac{t-T}{2T}\right) \cdot e^{i\pi k(t-T)^2}$$

En sortie du filtre dispersif 3 on obtient le signal suivant

$$s(t) = \int_{-\infty}^{+\infty} r\left(\frac{u}{T}\right) \cdot e^{-i\pi k u^2} \cdot f(u) \cdot r\left(\frac{t-u-T}{2T}\right) \cdot e^{i\pi k(t-u-T)^2} \, du$$

où f(t) désigne le signal à analyser. Or, pour un instant t compris dans l'intervalle [T/2, 3T/2], on a :

$$r\left(\frac{u}{T}\right) \cdot r\left(\frac{t-u-T}{2T}\right) = r\left(\frac{u}{T}\right)$$

Ainsi :

$$s(t) = \int_{-\frac{T}{2}}^{+\frac{T}{2}} e^{-i\pi k u^2} \cdot e^{i\pi k(t-T-u)^2} \cdot f(u) \, du$$

soit :

$$s(t) = \int_{-\frac{T}{2}}^{\frac{T}{2}} e^{-i\pi k u^2} \cdot e^{i\pi k(t-T)^2} \cdot e^{-2i\pi k(t-T)u} \cdot e^{ik\pi u^2} \cdot f(u) \, du$$

3

soit encore :

$$s(t) = e^{i\pi k(t-T)^2} \int_{-\frac{T}{2}}^{\frac{T}{2}} e^{-2i\pi k(t-T)u} \cdot f(u)du$$

On peut calculer s(t) pour un signal à analyser f(t) de la forme :

$$f(t) = A\,e^{2i\pi ft + i\phi}$$

où $\phi$ désigne la phase du signal f(t) à l'instant t = 0.

On obtient :

$$s(t) = Ae^{i\phi}\,e^{i\pi k(t-T)^2} \cdot T. \, \text{sinc}\,[\,\pi k(t-T-\frac{f}{k}) \cdot T\,]$$

où « sinc » désigne la fonction sinus cardinal. Pour supprimer la modulation de fréquence $\pi k(t - T)^2$, on mélange au signal s(t) le signal issu du filtre dispersif 5 déclenché à l'instant t = T/2. Le signal en sortie du filtre dispersif 5 est :

$$s_d(t) = r\,(\frac{t-T}{T}) \cdot e^{-i\pi k(t-T)^2}$$

Ce filtre peut être pris de même pente que le filtre dispersif 2, et dans ce cas il faut faire la somme des phases, ou bien de même pente que le filtre dispersif 3 et dans ce cas il faut faire la différence des phases. Ainsi on aboutit au signal de sortie :

$$s(t) = A.e^{i\phi} \cdot T \cdot \text{sinc}\,[\,\pi k(t-T-\frac{f}{k}) \cdot T\,]$$

valable pour t compris entre T/2 et 3T/2.

Il s'agit d'une impulsion ayant les caractéristiques suivantes :

— sa position dans le temps est T + (f/k), elle est donc fonction de la fréquence à analyser. Les bornes T/2 et 3T/2 correspondent aux fréquences f = — (B/2) et f = + B/2 ;

— son amplitude est proportionnelle à l'amplitude de la raie de la fréquence d'entrée (dans le lobe principal) ;

— sa phase est la phase du signal à analyser à l'instant t = 0 (tout au moins dans le lobe principal du sinus cardinal). En fait, cette phase est mesurée à un instant de référence $t = t_2 - (T/2)$ où $t_2$ est l'instant de déclenchement de l'impulsion de démodulation $\delta_2(t)$ (si le système est calibré, notamment en température, on a $t_2 = T/2$).

Le schéma de la figure 1 réalise donc bien les fonctions d'un transformateur de Fourier. Cependant, comme on a va maintenant le montrer plus en détail, ces résultats se trouvent quelque peu faussés par l'influence de la température. Lorsque la température subit une variation $\Delta\theta$, on a en effet les modifications suivantes, en se limitant pour ce calcul à la seule variation du paramètre T :

La pente k des filtres dispersifs devient : k' = B/T' avec T' = T + 2α (où 2α = C·Δθ·T).

Le coefficient C est le coefficient de température des filtres dispersifs. Si ceux-ci sont réalisés sur un substrat au Niobate de Lythium, on a : $C = - 10^{-4}/°C$.

A cette température, les équations des filtres dispersifs 2, 3 et 5 deviennent respectivement :

$$s_m(t) = r\,(\frac{t-\alpha}{T+2\alpha}) \cdot e^{-i\pi k'(t-\alpha)^2}$$

$$s_c(t) = r\,(\frac{t-T-2\alpha}{2T+4\alpha}) \cdot e^{i\pi k'(t-T-2\alpha)^2}$$

$$s_d(t) = r\,(\frac{t-T-\alpha}{T+2\alpha}) \cdot e^{-i\pi k'(t-T-\alpha)^2}$$

4

Pour un signal d'entrée f(t) de la forme :

$$f(t) = A.e^{2i\pi ft + i\phi}$$

et pour un instant t compris dans l'intervalle :

$$[\frac{T}{2} + 2\alpha, \frac{3T}{2} + 4\alpha]$$

Le signal de sortie de l'analyseur de spectre devient :

$$s(t) = A . e^{i\phi} . e^{-2i\pi k'\alpha(t-T-\alpha)} . e^{-2i\pi k'(t-T-3\alpha - \frac{f}{k'})\alpha}$$

$$. (T+2\alpha) . \text{sinc } \pi k' (t-T-3\alpha - \frac{f}{k'}) (T+2\alpha)$$

Le signal de sortie de l'analyseur de spectre a donc été modifié :
— la position dans le temps de l'impulsion a été décalée puisqu'elle est maintenant égale à T + 3α + (f/k') ;
— on remarque la présence de termes de phase parasites :

$$e^{-2i\pi k'\alpha(t-T-\alpha)} \text{ et } e^{-2i\pi k' (t-T-3\alpha - \frac{f}{k'}) \alpha}$$

Le deuxième terme n'est pas gênant car pour t = T + 3α + f/k', c'est-à-dire au sommet du lobe principal du sinus cardinal, il est nul. Par contre le premier correspond bien à un terme d'erreur affectant la mesure de la phase.

L'analyseur de spectre suivant l'invention représenté sur la figure 2 permet de s'affranchir de ce terme d'erreur. Cet analyseur a une structure différentielle obtenue au moyen d'un premier analyseur de spectre 6 identique à celui de la figure 1, recevant sur son entrée le signal à analyser f(t), et d'un second analyseur de spectre 7 identique à l'analyseur de spectre 6, mais recevant sur son entrée une impulsion de Dirac δ(t), appelée aussi signal de référence. L'analyseur de spectre 7 comporte, comme l'analyseur 6, deux mélangeurs 8 et 11, et trois filtres dispersifs 9, 10 et 12. Les impulsions de Dirac $\delta_1(t)$ et $\delta_2(t)$ sont communes aux deux analyseurs et le signal de sortie s(t) est obtenu en sortie d'un mélangeur 13 qui reçoit d'une part le signal de sortie du premier analyseur 6, d'autre part le signal de sortie du second analyseur 7.

Avec une telle structure, le terme d'erreur de phase mis en évidence précédemment est différentiellement annulé. On remarque que n'importe quel signal d'entrée de l'analyseur 7 permet d'obtenir ce résultat. Cependant, comme il n'y a que les différences entre le spectre du signal à analyser f(t) et le spectre du signal d'entrée de l'analyseur 7 qui subsistent en sortie du mélangeur 13, il est préférable d'utiliser une impulsion de Dirac δ(t) car le spectre d'une impulsion de Dirac suffisamment étroite est constant en module et a une phase nulle.

La forme de réalisation de l'analyseur de spectre représentée sur la figure 3 diffère de celle représentée sur la figure 2 en ce que les filtres dispersifs de modulation 2 et 9 sont remplacés par un seul filtre de modulation 14 et en ce que les filtres dispersifs de démodulation 5 et 12, ainsi que les mélangeurs 4 et 11 qui leur sont associés sont supprimés.

On montre maintenant qu'avec une telle structure, la mesure de phase n'est pas perturbée par des variations de température. Suivant le même raisonnement que précédemment, lorsque la température subit une variation Δθ, on a en effet les modifications suivantes :

La pente k des filtres dispersifs devient : k' = B'/T' avec B' = B + ΔB (où ΔB = — C·Δθ·B) et T' = T + 2α (où 2α = C·Δθ·T).

Le retard pur β des filtres dispersifs (dû essentiellement aux transducteurs) devient :

$$\beta' = \beta + \Delta\beta \quad \text{avec} \quad \Delta\beta = C \cdot \Delta\theta \cdot \beta$$

Le coefficient C est le coefficient de température des filtres dispersifs. Si ceux-ci sont réalisés sur un substrat au Niobate de Lythium, on a : C = — $10^{-4}$/°C.

A température ambiante, on a les équations suivantes :
— pour le filtre dispersif 14 de modulation, déclenché à t = — (T/2) — β :

$$s_m(t) = e^{-i\pi(2f_0 t + kt^2)} . r(\frac{t}{T})$$

— pour le filtre dispersif 3 de convolution :

$$s_c(t) = e^{i\pi [2f_1(t-T-\beta)+k(t-T-\beta)^2]} \cdot r(\frac{t-T-\beta}{2T})$$

$f_0$ et $f_1$ désignent respectivement la fréquence centrale des filtres 2 et 3. Lorsque la température subit une variation $\Delta\theta$, les fréquences $f_0$ et $f_1$ deviennent respectivement $f'_0 = f_0 + \Delta f_0$ et $f'_1 = f_1 + \Delta f_1$ avec $\Delta f_0 = -C\cdot\Delta\theta\cdot f_0$ et $\Delta f_1 = -C\cdot\Delta\theta\cdot f_1$.

A cette température, les équations des filtres dispersifs de modulation 14 et de convolution 3 s'écrivent respectivement :

$$s_m(t) = r(\frac{t-\alpha-\Delta\beta}{T+2\alpha}) \cdot e^{-i\pi [2f'_0(t-\alpha-\Delta\beta) + k'(t-\alpha-\Delta\beta)^2]}$$

$$s_c(t) = r(\frac{t-T-2\alpha-\Delta\beta}{2T+4\alpha}) \cdot e^{i\pi [2f'_1(t-T-\beta-2\alpha-\Delta\beta) + k'(t-T-2\alpha-\beta-\Delta\beta)^2]}$$

Par contre, à la différence du montage de la figure 1, le signal de démodulation est issu d'un filtre dispersif 10 de paramètres (2B, 2T) déclenché par une impulsion de Dirac centrée à l'instant $t = 0$ et mélangée au signal de modulation :

$$s_d(t) = r(\frac{t-T-\beta-2\alpha-\Delta\beta}{2T+4\alpha})$$

$$\cdot e^{i\pi [2f'_0(\alpha+\Delta\beta) - k'(\alpha+\Delta\beta)^2]}$$

$$\cdot e^{i\pi [2f'_1(t-T-2\alpha-\beta-\Delta\beta) + k'(t-T-2\alpha-\beta-\Delta\beta)^2]}$$

Pour un signal d'entrée f(t) de la forme :

$$f(t) = A \cdot e^{2i\pi f_2 t} \cdot e^{i\phi}$$

et pour un instant t compris dans l'intervalle :

$$[\frac{T}{2} + 2\alpha + \beta + \Delta\beta, \frac{3T}{2} + 4\alpha + \beta + \Delta\beta]$$

On obtient en sortie de l'analyseur de spectre :

$$s(t) = A \cdot e^{i\phi} \cdot e^{-2i\pi k'(t-T-3\alpha-\beta-2\Delta\beta - \frac{f'}{k'})(\alpha+\Delta\beta)}$$

$$\cdot (T + 2\alpha) \cdot sinc[\pi k'(t-T-3\alpha-\beta-2\Delta\beta - \frac{f'}{k'})(T+2\alpha)]$$

avec $f' = f_2 - f'_0 - f'_1$ (la fréquence $f_2$ du signal à analyser étant analysée par rapport à $f'_0 + f'_1$).

On remarque que pour l'instant $t = T + 3\alpha + \beta + 2\Delta\beta + (f'/k')$, c'est-à-dire à l'instant du maximum de l'impulsion de sortie, la phase du signal s(t) est égale à la phase $\phi$ du signal à analyser. Par conséquent cette structure permet bien de s'affranchir des erreurs sur la mesure de la phase. Elle présente de plus, par rapport au montage de la figure 2, l'avantage d'être beaucoup plus simple à réaliser et à mettre en œuvre.

Avec le montage de la figure 2 comme avec celui de la figure 3, la phase du signal de sortie de l'analyseur de spectre est la phase du signal à analyser à l'instant $t = 0$. Cependant, contrairement au schéma de la figure 1, l'instant $t = 0$ correspond à une référence de temps constituée par le déclenchement de l'impulsion de référence $\delta(t)$.

6

# EP 0 181 808 B1

**Revendications**

1. Analyseur de spectre à filtres dispersifs à ondes de surface, comportant un premier ensemble (6) à structure « M-C-M », c'est-à-dire dans lequel sont effectuées successivement des opérations de prémultiplication, convolution et postmultiplication, respectivement du signal à analyser, du signal obtenu à l'issue de la prémultiplication et du signal obtenu à l'issue de la convolution, par une première, une deuxième et une troisième rampe modulée linéairement en fréquence, ce premier ensemble recevant le signal à analyser (f(t)), et ces rampes de fréquences étant constituées par la réponse impulsionnelle de filtres dispersifs, respectivement appelés filtres de prémultiplication (2), de convolution (3) et de postmultiplication (5), caractérisé en ce qu'il comporte en outre, d'une part un second ensemble (7) à structure « M-C-M » identique au premier et recevant un signal de référence ($\delta$(t)), les filtres dispersifs respectivement de prémultiplication (2, 9) et de postmultiplication (5, 12) du premier et du second ensembles recevant respectivement le même signal de commande ($\delta_1$(t), $\delta_2$(t)), d'autre part un mélangeur (13) recevant les signaux de sortie du premier et du second ensembles, et fournissant le signal de sortie de l'analyseur de spectre.

2. Analyseur selon la revendication 1, caractérisé en ce que le signal de référence est une impulsion de Dirac.

3. Analyseur de spectre selon l'une des revendications 1 et 2, modifié en ce que le premier (6) et le second (7) ensembles à structure « M-C-M » sont remplacés par un premier et un second ensembles à structure « M-C », c'est-à-dire dans laquelle ne sont effectuées que les opérations de prémultiplication et de convolution, le mélangeur fournissant le signal de sortie de l'analyseur de spectre recevant alors les signaux de sortie des filtres dispersifs de convolution du premier et du second ensembles.

4. Analyseur selon l'une des revendications 1 à 3, modifié en ce que les filtres dispersifs de prémultiplication (2, 9) sont remplacés par un seul filtre dispersif de prémultiplication (14), commun au premier et au second ensembles.

**Claims**

1. A spectrum analyser using surface wave dispersion filters and comprising a first assembly (6) of a structure « M-C-M », i. e. a structure in which successively premultiplication, convolution and postmultiplication operations are performed respectively on the signal to be analyzed, the signal issuing from the premultiplication and the signal issuing from the convolution, by a first, a second and a third linearly frequency modulated ramp, this first assembly receiving the signal to be analyzed (f(t)), and these frequency ramps being constituted by the pulse response of the dispersion filters, respectively called premultiplication (2), convolution (3) and postmultiplication ramp (5), characterized in that it further comprises, on the one hand, a second assembly (7) having a structure « M-C-M » which is identical to that of the first assembly, the second assembly receiving a reference signal ($\delta$(t)), the premultiplication (2, 9) and postmultiplication dispersion filters of the first and second assemblies respectively receiving the same control signal ($\delta_1$(t), $\delta_2$(t)), and on the other hand a mixer (13) receiving the output signals from the first and the second assemblies and supplying the output signal of the spectrum analyser.

2. An analyser according to claim 1, characterized in that the reference signal is a DIRAC pulse.

3. A spectrum analyser according to one of claims 1 and 2, modified in such a way that the first (6) and the second assemblies (7) of « M-C-M »-structure are replaced by a « M-C »-structure, i. e. by a structure in which only the premultiplication and the convolution operations are performed, the mixer, which supplies the output signal of the spectrum analyser, receiving in this case the output signals of the convolution dispersion filters of the first and the second assemblies.

4. An analyser according to one of claims 1 to 3, modified in such a way that the premultiplication dispersion filters (2, 9) are replaced by a unique premultiplication dispersion filter (14) which is common to the first and the second assemblies.

**Patentansprüche**

1. Spektralanalysator unter Verwendung von Oberflächenwellen-Dispersionsfiltern, mit einer ersten Einheit (6) einer Struktur « M-C-M », d. h. in der nacheinander eine Vormultiplikation, eine Konvolution und eine Nachmultiplikation des zu analysierenden Signals bzw. des am Ausgang der Vormultiplikation erhaltenen Signals bzw. des am Ausgang der Konvolution erhaltenen Signals mit einer ersten bzw. zweiten bzw. dritten linear frequenzmodulierten Rampe erfolgt, wobei die erste Einheit das zu analysierende Signal (f(t)) zugeführt erhält und diese Frequenzrampen durch die Impulsantwort von Dispersionsfiltern gebildet werden, welche Vormultiplikationsfilter (2), Konvolutionsfilter (3) und Nachmultiplikationsfilter (5) genannt werden, dadurch gekennzeichnet, daß er außerdem einerseits eine zweite Einheit (7) derselben Struktur « M-C-M » besitzt, die ein Bezugssignal ($\delta$(t)) zugeführt erhält, wobei die Dispersionsfilter für die vormultiplikation (2, 9) bzw. Nachmultiplikation (5, 12) der beiden Einheiten dasselbe Steuersignal ($\delta_1$(t), $\delta_2$(t)) zugeführt erhalten, und andererseits einen Mischer (13) besitzt, der die Ausgangssignale der beiden Einheiten empfängt und das Ausgangssignal des Spektralanalysators liefert.

2. Analysator nach Anspruch 1, dadurch gekennzeichnet, daß das Bezugssignal ein DIRAC-Impuls ist.

3. Spektralanalysator nach einem der Ansprüche 1 und 2, dadurch modifiziert, daß die beiden Einheiten mit « M-C-M »-Struktur durch eine erste bzw. zweite Einheit mit « M-C-M »-Struktur ersetzt sind, d. h. in der nur die Vormultiplikation und die Konvolution durchgeführt werden, wobei der Mischer, der das Ausgangssignal des Spektralanalysators liefert, dann die Ausgangssignale der Konvolutions-Dispersionsfilter der beiden Einheiten zugeführt erhält.

4. Analysator nach einem der Ansprüche 1 bis 3, dadurch modifiziert, daß die Vormultiplikations-Dispersionsfilter (2, 9) durch ein einziges Vormultiplikations-Dispersionsfilter (14) ersetzt sind, das beiden Einheiten gemeinsam ist.

Fig.1

Fig.2

Fig.3